Europäisches Patentamt

European Patent Office

Office européen des brevets

(11) Publication number: **0 294 864**
**A2**

# EUROPEAN PATENT APPLICATION

(21) Application number: 88201012.7

(22) Date of filing: 20.05.88

(51) Int. Cl.4: **H01L 21/316 , H01L 21/82 , H01L 27/10 , H01L 29/78**

(30) Priority: **11.06.87 IT 2087487**

(43) Date of publication of application:
**14.12.88 Bulletin 88/50**

(84) Designated Contracting States:
**DE FR GB NL SE**

(71) Applicant: **SGS-THOMSON MICROELECTRONICS S.p.A.**
**Stradale Primosole 50**
**I-95121 Catania (CT)(IT)**

(72) Inventor: **Camerlenghi, Emilio**
**Via Zendrini, 2**
**I-24100 Bergamo(IT)**
Inventor: **Caprara, Paolo**
**Via Tolentino, 17/1**
**I-20155 Milano(IT)**
Inventor: **Crisenza, Giuseppe**
**Via 11 Febbraio, 7/F**
**I-20056 Trezzo Sull'Adda(Milano)(IT)**

(74) Representative: **Mittler, Enrico et al**
**c/o Marchi & Mittler s.r.l. Viale Lombardia, 20**
**I-20131 Milano(IT)**

(54) Fabrication process for electrically cancellable nonvolatile EPROM memory cells and the cell thus obtained.

(57) The process calls for deposit of channel doping (1) on a semiconductor substrate (20); on the channel doping zone (1) is overlaid gate oxide (3) in a thin film which is deposited between doped side zones (4) on which are overlain areas of field oxide (2). On the layer of gate oxide (3) are placed a first polysilicon layer (5), an intermediate dielectric layer (9) and a second polysilicon layer (12). Selected surfaces of said deposited layers and said gate oxide layer (3) are removed to form a source junction zone (17) and a drain junction zone (18). The cell thus prepared is subjected to a source and drain reoxidation phase in a dry environment at a temperature of approximately 900°C. Then the contact opening, metallization and passivation operations are performed.

Fig. 13

## "Fabrication process for electrically cancellable nonvolatile EPROM memory cells and the cell thus obtained"

The present invention relates to a fabrication process for electrically cancellable nonvolatile EPROM memory cells and a cell obtained by said process.

It is known that nonvolatile memory cells are divided in two principal classes, to wit EEPROM electrically writable and cancellable cells and EPROM electrically writable cells cancellable with ultraviolet rays.

Compared with the obvious advantages due to electrical cancellation, an EEPROM process calls for the use of several critical technological steps linked generally to the requirement for thin oxides (less than 100A) which permit tunnelling of the carriers but at the same time assure sufficient information retention capacity by the cell. In addition this type of memory calls for a selection transistor for each cell and therefore occupies a large space.

Contrariwise an EPROM process generally uses less critical technologies and also produces a memory cell with a much smaller area. At the same time there is the problem of cancellation by ultraviolet rays which involves (a) handling of the chip when removing it from its supporting card for exposure to ultraviolet radiations and (b) the added cost introduced by the necessity of including in the chip container (the so-called 'package') a quartz lens transparent to ultraviolet rays.

The ideal solution is represented by the so-called 'flash EPROM' cells which can be obtained by an EPROM process but are electrically cancellable and thus unite the advantages of EPROM cells with those of EEPROM cells.

Said flash EPROM cells are also profitable as compared with OTP (one time programming) EPROM cells since they have an economical container without a quartz lens. Compared with them the flash EPROM cells make it possible to complete cell writing trials performed on the closed part after incapsulation, said writing being subsequently electrically cancellable.

The literature contains examples of electrically cancellable EPROM cells which use a writing mechanism based on the injection of hot electrons, i.e. whose energy is such as to permit overcoming the potential barrier between silicon and silicon oxide.

A first example is an electrically cancellable EPROM memory cell proposed by Mong-Song Lian and Tien-Chiun Lee (IEEE Electron Device Letters, Vol. 7, No. 8, August 86) in which, for cancellation purposes, hot holes (which may be thought of as positive charges capable of overcoming the Si-SiO$_2$ potential barrier) are injected in the floating gate when a so-called snap-back condition (meaning ignition of the NPN parasite bipolar transistor consisting of the three regions: source, channel and drain) is set up in the cell. When an MOS structure is brought into snap-back the currents running through the structure become quite strong. In a C-MOS device these currents can set off a parasite phenomenon known as 'latch-up', which can lead to destruction of the device.

A second example of an electrically cancellable EPROM cell is reported by S. Mkberjee et al in IEDM 85, page 618. The structure uses for cancellation the phenomenon of electrons tunnelling in the gate oxide from the floating gate to the source, grounding the control gate, and applying a high voltage to the source. But this makes necessary very thin gate oxides (less than 200A). In addition the requirement for high voltages at the source electrode produces very critical cancellation conditions which can be reflected in problems of reliability of the structures in question.

Finally, F. Masuoka and others have produced an electrically cancellable EPROM cell which is obtained using three successive deposits (and associated photolithografic definitions) of layers of polycrystalline silicon in such a manner as to produce a cancellation gate in addition to the two usual gates. The cell is programmed by the injection of hot electrons in a manner similar to what is done in normal EPROM cells. Cancellation is secured by using the phenomenon of carrier tunnelling through the oxide layer included between the floating gate and the cancellation gate. This solution, in addition to involving considerable complexity due the the presence of a triple layer of polycrystalline silicon, introduces the uncertainty of not being able to control the mechanism of tunnelling through an oxide grown on a layer of polycrystalline silicon and therefore quite rough. The risk is that all the cells of the device may be cancelled simultaneously.

In view of the known art the object of the present invention is to accomplish an electrically cancellable EPROM cell in which the abovementioned drawbacks of the known art do not occur.

In accordance with the invention said object is achieved by a fabrication process for electrically cancellable EPROM cells calling for the deposit of a first layer of polysilicon on a substrate having a channel implantation with a superimposed thin layer of gate oxide, deposit of an intermediate dielectric layer, deposit of a second layer of polysilicon and deposit of a layer of covering oxide, removal of said deposited layers outside of a selected gate area to form source and drain junction implantation zones, characterized in that it also comprises a reoxidation phase of the source and drain zones in a dry environment.

Reoxidation in a dry environment (term used to indicate a particular technology which uses a flow of oxygen and nitrogen for oxidation) limits deformation of the cell gate due to unwanted growth of oxide between the two polysilicon levels and is reflected in less capacitive coupling and hence less efficiency in writing the cell.

Again in accordance with the invention care is also taken to provide a channel implantation (called 'threshold shift') which, in addition to heat treatment at a relatively low temperature, gives rise to a dope profile and hence to a very superficial electrical field.

Applying to the drain and gate of the device described above an appropriate pair of voltages (gate voltage tending toward zero and high positive-drain voltage), two conditions are secured simultaneously, to wit a strong longitudinal electrical field with the resulting generation of hot carriers and a transversal electrical field favorable for the injection of holes in the floating gate.

The peculiar dope profile used makes this last mechanism more efficient than the competitive phenomenon of injection into the substrate, which can cause triggering of snap-back.

Thus an EPROM cell simple in structure has been obtained which uses hot holes for channelling without however triggering dangerous and uncontrollable phenomena.

The process in accordance with the invention is illlustrated as an example in the annexed drawings wherein:

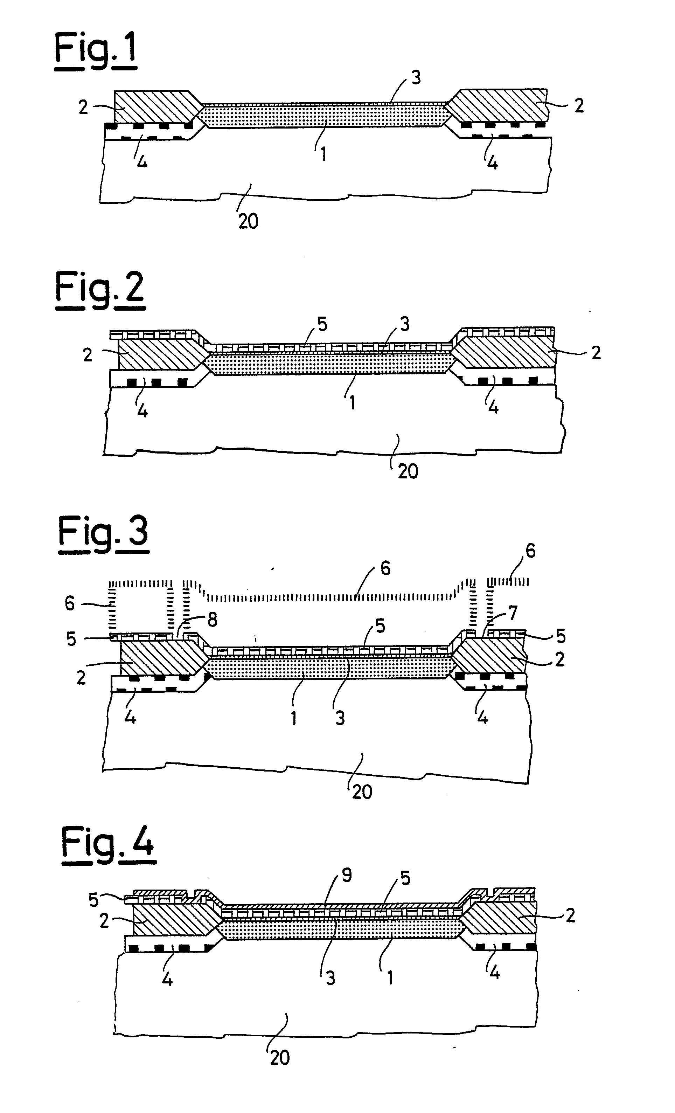

FIGS. 1-13 show schematically cross sections of the various phases of the abovesaid process for fabrication of an electrically cancellable nonvolatile EPROM memory cell.

FIG. 1 shows a silicon substrate 20 provided with a channel implantation 1 and doped side zones 4 on which is grown field oxide 2 constituting electrical insulation structures. In the channel implantation zone 1 is grown a thin layer of gate oxide 3. To secure the entirety of FIG. 1 a normal known Planox process is used.

On the unit thus formed, as shown in FIG. 2, is deposited a first polysilicon layer 5 which is also appropriately doped. Then a mask 6 is applied and covers the entire layer 5 except zones 7 and 8, which coincide with the field oxide areas 2. Then the polysilicon layer 5 is removed where it coincides with said zones 7 and 8 (FIG. 3).

After removal of the mask 6 (called 'first poly') an intermediate dielectric 9 (FIG. 4) consisting of a triple layer (ONO) of silicon oxide, silicon nitride and silicon oxide is grown and deposited. Growth/deposit temperature is approximately 900° C.

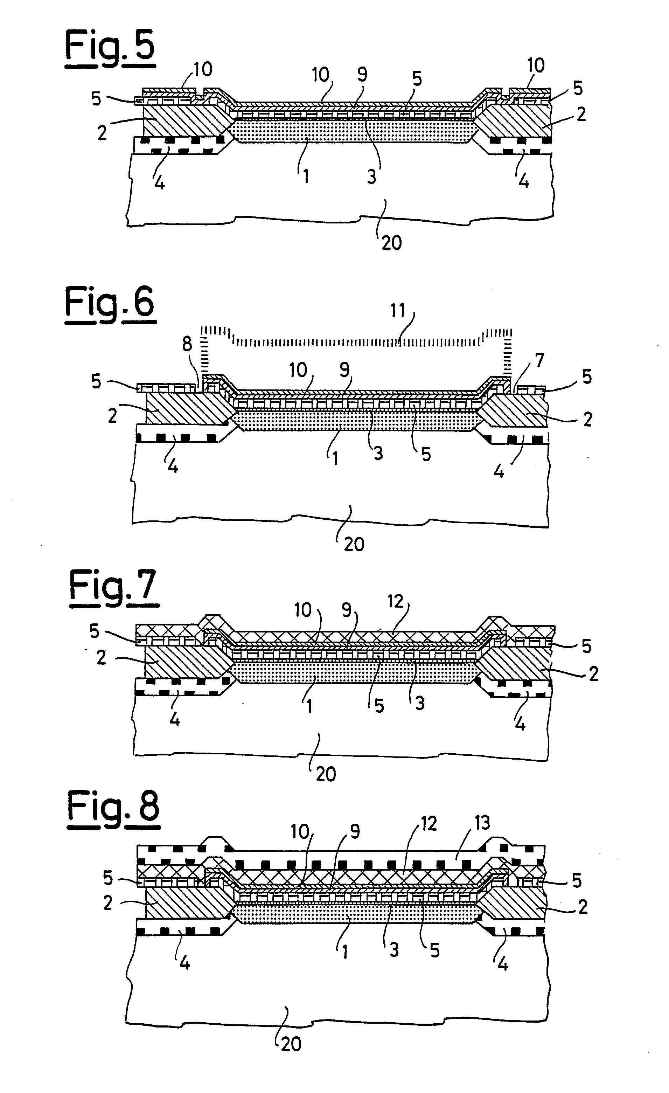

Then a supplementary or 'fictitious' layer (as it does not play any electrical connection role) of polysilicon 10 (FIG. 5) is deposited at a temperature of approximately 600° C.

Subsequently a mask 11 covering the entire surface included between the zones 7 and 8 is applied to the structure.

In the areas unprotected by the mask 11 are then performed in succession etching of the supplementary layer of polysilicon 10 and ONO dielectric 9 (FIG. 6).

The mask 11 is removed and then a second layer of polysilicon 12 is deposited (optionally with the addition of silicide) which is then doped (FIG. 7). The temperature in this phase is approximately 600° C. On the layer 12 is applied a layer 13 consisting of tantalium silicide ($TaSi_2$) or alternatively polysilicon (FIG. 8).

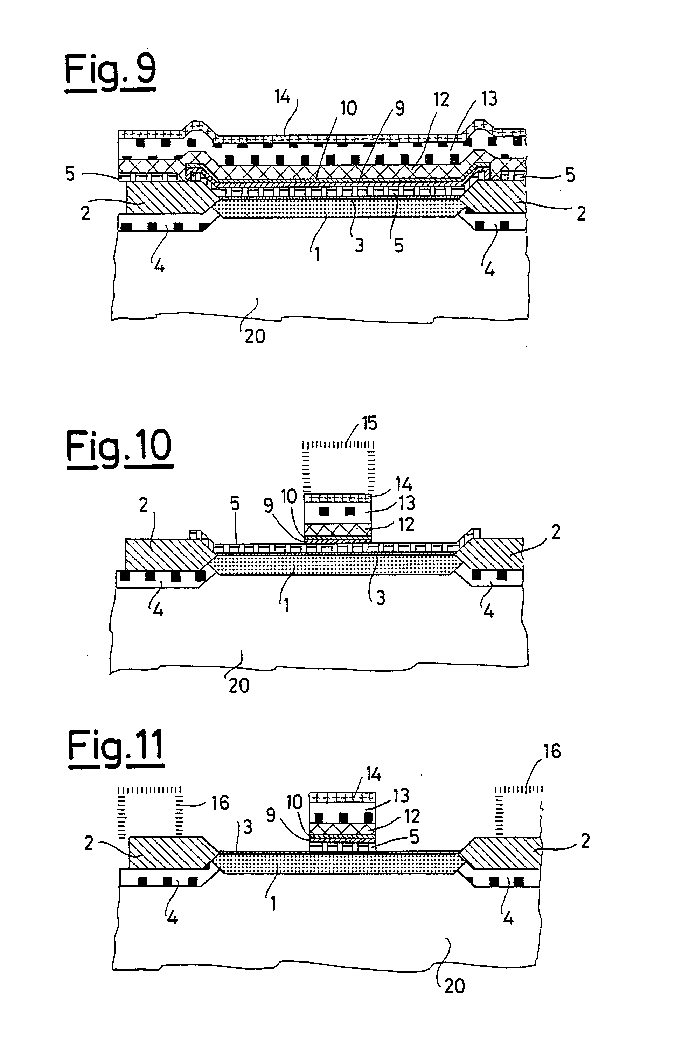

As shown in FIG. 9 on the layer 13 is deposited a covering oxide layer 14 (FIG. 9).

Then a mask 15 (termed 'second poly') is applied in the central zone of the cell (FIG. 10) and the covering oxide layer 14, the tantalimum silicide layer 13, the second polysilicon layer 12, the optional supplementary polysilicon layer 10, and the ONO dielectric layer 9 are then etched. Only the first polysilicon layer 5 and the underlying gate oxide 3 are left. The mask 15 is removed and the self-aligning mask 16 is applied to remove the first polysilicon layer 5 and then the gate oxide layer 3. Protection of the remaining portion of the tantalium silicide layer 13 and the second polysilicon layer 12 is assured by the covering oxide layer 14 (FIG. 11). The source and drain junctions 17 and 18 are then doped on the cell by implantation (FIG. 12).

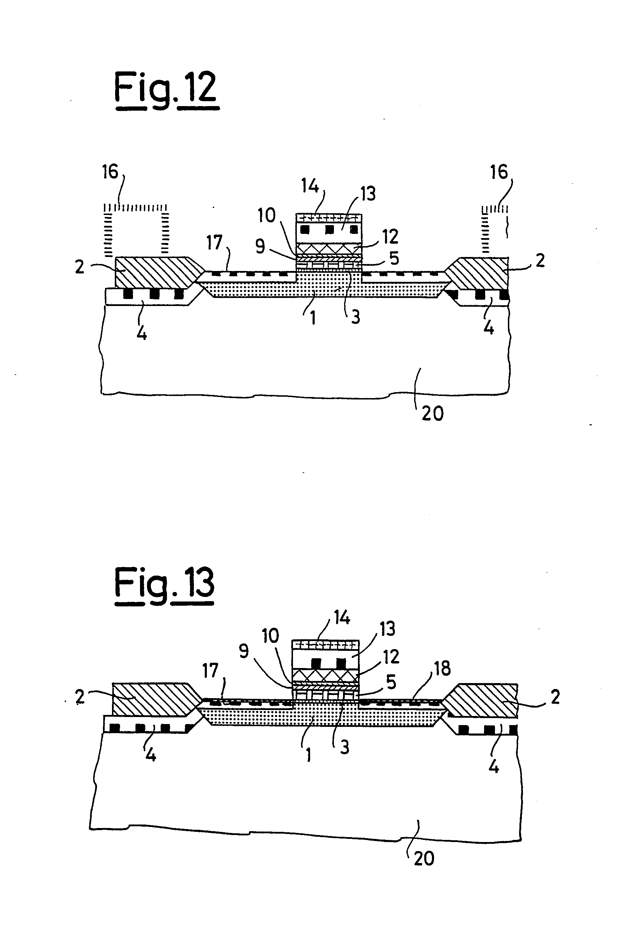

After implantation the self-aligning mask 16 is removed and the source and drain are reoxidized in a dry environment at a temperature of approximately 900° C (FIG. 13).

In this condition growth of the oxide on the junction at the edges of the structure is controlled and the structure itself thus remains undeformed.

After reoxidation the finishing (not shown), contact opening, metallization and passivation phases are completed.

In this manner is obtained an electrically alterable EPROM memory cell the electrical cancellation of which is achieved by polarizing the drain electrode at high voltage (like that required for the writing phase) while the gate electrode is held at a lower voltage, close to ground voltage.

## Claims

1. Fabrication process for electrically cancellable EPROM cells consisting of the deposit of a first polysilicon layer (5) on a substrate (20) having a channel implantation (1) with an overlying thin layer of gate oxide (3), the deposit of an intermediate dielectric layer (9), deposit of a second polysilicon layer (12) and deposit of a covering oxide layer (14), removal of said deposited layers (5, 9, 12, 14) outside of a selected area to form implantation zones for a source junction (17) and a drain junction (18) characterized in that it also comprises a reoxidation phase of the source and drain zones (17, 18) in a dry environment.

2. Process in accordance with claim 1 characterized in that said source and drain reoxidation is performed at 900° C.

3. Process in accordance with claim 1 characterized in that it calls for treatment temperatures equal to or less than 900° C.

4. Process in accordance with claim 1 characterized in that it calls for the formation of a very thin superficial channel doping profile (1).

5. Process in accordance with claim 1 characterized in that between said intermediate dielectric layer (9) and said second polysilicon layer (12) there is placed a supplementary, or 'fictitious', layer of polysilicon (10).

6. Process in accordance with claim 3 characterized in that between said second polysilicon layer (12) and said covering oxide layer (14) is placed an optional layer (13) of tantalium silicide (TaSi$_2$).

7. Electrically alterable EPROM memory cell obtained by the process according to the above claims chacterized in that it comprises a channel implantation (1) with overlain gate oxide (3) in thin layer placed between areas of field oxide (2), a first polysilicon layer (5), an intermediate dielectric layer (9), a supplementary polysilicon layer (10), a second polysilicon layer (12) and an optional tantalium silicide layer (13).

EP 0 294 864 A2

## Fig.1

## Fig.2

## Fig.3

## Fig.4

EP 0 294 864 A2

**Fig.5**

**Fig.6**

**Fig.7**

**Fig.8**

# Fig.9

# Fig.10

# Fig.11

EP 0 294 864 A2

# Fig.12

# Fig.13